# EUROPEAN PATENT SPECIFICATION

(11) **EP 2 543 750 B1**
(45) Date of publication and mention of the grant of the patent: **05.06.2019**
(21) Application number: 11739780.2
(22) Date of filing: 02.02.2011
(51) Int. Cl.: H01L 23/373, C25D 15/02

(54) **HEAT SINK MATERIAL**
KÜHLKÖRPERMATERIAL
MATÉRIAU DISSIPATEUR DE CHALEUR

(30) Priority: 04.02.2010 JP 2010022788
(43) Date of publication of application: 09.01.2013
(73) Proprietor: Nippon Precision Jewel Industry Co., Ltd, Mikata-gun, Hyogo 669-6701 (JP)
(72) Inventor: NAKAGAWA Kazushi, Mikata-gun Hyogo 669-6701 (JP); NAKAMURA Yoshihiro, Mikata-gun Hyogo 669-6701 (JP); YAMAMOTO Shinya, Mikata-gun Hyogo 669-6701 (JP); MATSUMURA Sowjun, Toyonaka-shi Osaka 560-0025 (JP)
(74) Representative: Mewburn Ellis LLP
(86) International application number: PCT/JP2011/052145
(87) International publication number: WO 2011/096432

(56) References cited:
- JP-A- 6 272 093
- JP-A- 8 311 696
- JP-A- 10 310 893
- JP-A- 2008 155 362
- US-B2- 6 987 318

## Description

### TECHNICAL FIELD

This invention relates to a heat sink material and more particularly, to a heat sink material that not only is excellent in heat sink properties, but also allows molded articles of various shapes made of a variety of materials to be utilized as a base substrate thereof such as for mobile objects including particularly vehicles, automobiles and the like. The heat sink material has excellent durability on use as a heat sink material, and can be thinned and thus conveniently employed as a heat sink material for semiconductor devices, particularly for cell phones, personal computers and the like.

### BACKGROUND ART

Heat sink materials have been hitherto installed in apparatus in order to efficiently dissipate, to outside, heat generated upon operation of electronic parts in the apparatus. Diamond is a substance excellent in heat sink properties and has been thus utilized as a heat sink material. For instance, in Patent Document 1, it is described that polycrystalline diamond is grown on a polycrystalline Si substrate according to a hot filament CVD (chemical vapor deposition) method to obtain a diamond heat sink substrate, followed by forming a diamond self-supported film by application of an excimer laser after dissolution of the base substrate to provide divided diamond base substrates. In Patent Document 2, there is described an integrated circuit package including a diamond heat sink using, as a base substrate, a diamond thin film formed by the CVD method. Moreover, in Patent Document 3, there is described the use, as a heat sink plate for electronic parts, etc., of a diamond film formed by a CVD (chemical vapor deposition) method.

In Patent Document 4, it is stated that flexible thermal-conductive sheets such as of silicone rubbers have been hitherto used for the purpose of promoting heat transmission between a heat-generating semiconductor element or electronic part and a heat-transfer member for heat sinking, and a particulate thermal-conductive filler such as of diamond is formulated in these thermal-conductive sheets. In Patent Document 5, there is exemplified diamond for use as a thermal-conductive filler that is contained in a thermal-conductive silicone composition used in electronic devices excellent in heat sink properties. Moreover, in Patent Document 6, there is described a heat sink member obtained by placing diamond particles in a frame serving as a tool for a given type of heat sink member, packing the particles densely while shaking, flowing a powdery or paste-form metal into the frame for heat sink member to form a composite material of the diamond particles and the metal in such a state that the diamond particles are arranged in a single layer, repeating the above procedure to provide a built-up body of a given thickness, and heating in vacuum to melt the metal powder or sintering the paste-form metal to provide a composite material of the diamond particles and the metal. In Patent Document 7, there is described a light-emitting diode wherein a diamond-metal heat sink obtained by mixing diamond particles and a metal powder and pressing is connected to a p-type electrode.
In Patent Document 8 diamond particles of about ≤ 38 µm particle diameter are suspended in a high heat conductivity metal plating bath such as a copper plating bath and a composite plating layer consisting of diamond particles and the metal is formed on a substrate of metal, ceramic or plastic while uniformly distributing the particles by stirring or circulating the solution.

### PRIOR ART DOCUMENT

### PATENT DOCUMENT

Patent Document 1: Japanese Patent Laid-open No. Hei 7-58256
Patent Document 2: Japanese Patent Laid-open No. Hei 8-46070
Patent Document 3: Japanese Patent Laid-open No. Hei 8-267644
Patent Document 4: Japanese Patent Laid-open No. 2002-88171
Patent Document 5: Japanese Patent Laid-open No. 2007-214224
Patent Document 6: Japanese Patent Laid-open No. 2008-135532
Patent Document 7: Japanese Patent Laid-open No. 2004-200347
Patent Document 8: Japanese Patent Laid-open No. Hei 10-310893

However, with the case where diamond particles are surface-treated by the CVD method, treatment at high temperatures is essential and thus, a problem on the heat resistance of an object to be treated has been involved in some cases. On the other hand, with pressing, a molding frame is necessary with some difficulty in applying to complicated shapes. Thus, limitation is placed on the shape of the resulting heat sink material. With a resin sheet containing diamond particles, it would be supposed that limitation is placed on the manner of use and a problem on attaching strength is presented. Moreover, with semiconductor devices, particularly, those devices used for personal computers, and cell phones, since it is desirable that the heat sink material per se be made thin, there has been a demand for development of a heat sink material capable of being thinned.

### SUMMARY OF THE INVENTION

### PROBLEMS TO BE SOLVED BY THE INVENTION

The invention has been made under such circumstances as stated above and has for its object the provision of a heat sink material, which not only is excellent in heat sink properties, but also permits molded articles of various shapes made of a variety of material to be utilizable as a base substrate for heat sink material and which is excellent in durability as a heat sink material, enables itself to be thinned, and can be conveniently used as a heat sink material for semiconductor devices, particularly, for cell phones, personal computers, mobile objects and the like.

### MEANS FOR SOLVING THE PROBLEMS

The present inventors have intensively studied to achieve the above object and found that a molded product for use as a heat sink material is provided as a base substrate and an electroplated film is formed on a given portion of the base substrate by use of a composite plating solution dispersing diamond particles in a metal plating solution whereby molded products of various shapes made of a variety of material can be used as a base substrate for heat sink material and thin film formation is enabled. It has also been found as a result of further intensive studies that when a plated metal film is provided as a matrix and diamond particles are dispersed in the matrix thereby forming a composite electroplated film wherein a co-deposition amount (content or dispersion amount) of the diamond particles in the matrix are gradually changed in the thickness direction of the film thereby forming a functionally graded material (FGM: Functionally Graded Material or an inhomogeneous dispersion system), i.e. when a composite electroplated film having the functional gradation is formed, heat sink properties ascribed to the plated film can be improved and adhesion of the plated film to the base substrate can be more improved further thereby reliably preventing troubles such as peeling-off, and falling of the plated film, thereby accomplishing the invention. Moreover, further intensive studies have been made on a heat sink material having an electroplated film formed by use of a composite plating solution dispersing diamond particles in a metal plating solution as in the invention. From a result of this study, it has been found that since it is desirable that thermal vibrations occur among diamond particles being in mutual contact, the diamond particles co-deposited in the composite electroplated film is preferably in as close a contact as possible and found that the diamond particles in a co-deposited state where they mutually contact with one another in the film ensure more excellent heat sink properties.

More particularly, the invention provides a heat sink material, characterized by including a composite electroplated film including a plated metal film as a matrix and diamond particles that are co-deposited in the matrix in such a way that a co-deposition amount thereof gradually changes in a thickness direction of the electroplated metal film. The average particle size of the diamond particles determined by a laser diffraction-type particle size distribution measuring method is preferably at 0.01 to 350 µm. It is further preferred that the thickness of the composite electroplated film is at 1 to 5000 µm and a metal source for forming a plated metal film is one or two or more selected from copper, nickel, gold, silver, tin, cobalt, iron, zinc and chromium.

More specific configurations of the composite electroplated film include: (1) a composite electroplated film wherein an amount of co-deposited diamond particles in the matrix gradually increases from a base substrate side, on which a composite electroplated film is formed, toward a side of the film surface; (2) a composite electroplated film wherein not only the amount of the co-deposited diamond particles in the matrix gradually increases from the base substrate side, on which the composite electroplated film is formed, toward the film surface side, but also the diamond co-deposited film wherein the diamond particles are exposed to the film surface is further formed on the film surface thereof with a plated surface metal film formed from a metal source of a different type of a metal source forming the plated metal film, i.e. a composite electroplated film including a plated surface metal film formed from a metal source of a different type of a metal source forming the plated metal film wherein the plated surface metal film is formed on the film surface of the diamond co-deposited film exposing the diamond particles on the film surface of the composite electroplated film described in (1), and with this configuration (2), it is preferred that the thickness of the plated surface metal film is not larger than 4/5 of the average particle size of the diamond particles in the diamond co-deposited film and that the metal source used to form the plated surface metal film is copper, silver, gold or iron; (3) a composite electroplated film wherein an amount of co-deposited diamond particles in the matrix gradually decreases from a side of the base substrate covered with the composite electroplated film toward a film surface side; and (4) a composite electroplated film wherein an amount of co-deposited diamond particles in the matrix gradually increases from a base substrate side covered with the composite electroplated film toward an intermediate portion in the thickness direction of the film and gradually decreases from the intermediate portion toward a film surface side.

The co-deposited state of the diamond particles in the composite electroplated film of the heat sink material of the invention may be such that so far as the diamond particles are co-deposited so as to permit an amount of the co-deposited diamond particles in the matrix made of a plated metal film to gradually increase in the thickness direction of the plated metal film, the diamond particles in the plated metal film are co-deposited either in mutual noncontact state or in mutual contact state. The co-deposition of the diamond particles in mutual contact state at at least a part of the plated metal film is preferred for the reason that thermal vibrations occur among diamond particles being in mutual contact as set out hereinabove. Moreover, the co-deposition amount of diamond particles in the plated metal film gradually changes relative to the thickness direction of the plated metal film whereby the heat sink properties of the composite electroplated film, in which the diamond particles are co-deposited, are improved.

As a base substrate forming the composite electroplated film thereon, mention is made of metal products (molded articles) are applicable. In the practice of the invention, there may be further mentioned a heat sink material including a base substrate wherein a glass molded article is covered with such a composite electroplated film as mentioned above and more particularly, for example, a heat sink material of the type wherein a glass molded article having a metal, such as palladium, adsorbed and plated thereon is formed on the plated surface with such a composite electroplated film, or a heat sink material wherein a plastic molded article is used as a base substrate, on which the composite electroplated film is formed and more particularly, for example, a heat sink material of the type wherein the composite electroplated film is formed on a plated surface of a plastic molded article having a metal, such as palladium, adsorbed and plated on the surface thereof.

Further, the heat sink material of the invention may be used as a heat sink material of semiconductor devices, e.g. as a heat sink material of semiconductor devices employed in various types of parts of mobile bodies such as vehicles, and automobiles. In particular, use as a heat sink material for cell phones or personal computers is preferred. Additionally, it is also preferred to use the heat sink material for optical devices.

### EFFECTS OF THE INVENTION

According to the invention, there can be obtained a heat sink material, which not only is excellent in heat sink properties, but also can be used as a heat sink material for molded articles of various shapes made of a variety of materials, is excellent in durability when in use as a heat sink material, enables itself to be thinned, and can be favorably utilized as a heat sink material for semiconductor devices and particularly, for those of cell phones, and personal computers.

### BRIEF DESCRIPTION OF DRAWINGS

Fig. 1 is a schematic longitudinal sectional view of a heat sink material illustrating the first configuration example of a heat sink material of the invention.
Fig. 2 is a schematic longitudinal sectional view of a heat sink material illustrating the second configuration example of a heat sink material of the invention.
Fig. 3 is a schematic longitudinal sectional view of a heat sink material illustrating the third configuration example of a heat sink material of the invention.
Fig. 4 is a schematic longitudinal sectional view of a heat sink material illustrating the fourth configuration example of a heat sink material of the invention.
Fig. 5 is a schematic longitudinal sectional view of a heat sink material illustrating the fifth configuration example of a heat sink material of the invention.
Fig. 6 is a schematic longitudinal sectional view of a heat sink material illustrating the sixth configuration example of a heat sink material of the invention.
Fig. 7 is a schematic longitudinal sectional view of a plating apparatus illustrating an example of an apparatus of forming a composite electroplated film according to the invention.
Fig. 8 is a schematic longitudinal sectional view of a heat sink material illustrating reference of a heat sink material of the invention.
Fig. 9 is a longitudinal sectional view, partially enlarged, of the heat sink material schematically shown as enlarging Z portion of Fig. 8.

### MODE FOR CARRYING OUT THE INVENTION

The invention is now described in more detail. The heat sink material of the invention includes a composite electroplated film including a plated metal film as a matrix and diamond particles, which are co-deposited in the matrix (metal matrix) in such a way that a co-deposition amount of the diamond particles gradually changes relative to the thickness direction of the plated metal film. A base substrate (molded article) is covered with the composite electroplated film wherein the diamond particles are dispersed in the metal matrix, so that easy surface treatment even on a base substrate (molded article) of a complicated shape is possible. It also improves selectivity and degree of freedom in shape of the heat sink material, and allows thinning of the film. Since the plated film is formed by electroplating, no high temperature treatment is needed at applying surface treatment on the base substrate. For instance, there can be used, as a base substrate, molded articles made of materials, such as plastics and glass, which are unsuited for high-temperature treatment. Moreover, diamond particles, which are excellent in heat sink properties but have relatively low affinity for other types of materials because of the difference in physical properties with other materials such as metals, are co-deposited in such a way that the co-deposition amount gradually changes relative to the thickness direction of the plated metal film. Accordingly, the resulting plated film shows high affinity for other types of materials and becomes difficult to peel off or crack. It also becomes possible to enhance heat sink properties of the heat sink material, improve an abrasion resistance on the surface of the heat sink material, further improve the surface strength and protect an inner structure.

Next, the diamond particles and plated metal film forming the composite electroplated film of the heat sink material of the invention are described in more detail.

The diamond particles used in the invention include, for example, ones appropriately selected from commercially available diamond particles as shown in examples appearing hereinafter. The average particle size is preferably at 0.01 to 350 µm, more preferably at 1 to 250 µm and further preferably at 15 to 200 µm. If the average particle size is larger, the filling density may become lower relative to the film thickness. With a smaller particle size, the filling density may become higher, resulting in lower film strength. The average particle sizes of diamond particles herein are measured according to a laser diffraction-type particle size distribution measuring method.

As a metal source for forming the metal matrix of the composite electroplated film of the invention, no specific limitation is placed thereon. Preferred examples include copper (Cu), nickel (Ni), gold (Au), silver (Ag), tin (Sn), cobalt (Co), iron (Fe), zinc (Zn), and chromium (Cr). Taking thermal conduction into consideration, nickel, copper and silver are more preferred among them, and particularly nickel and copper are preferred. These may be used solely or in combination of two or more.

The co-deposition amount (dispersion amount) of diamond particles in the metal matrix is not specifically limited, but taking into account properties such as film strength, toughness, ductility, hardness, and mechanical strength, the preferable total co-deposition amount in the film is at 1 to 45 vol%, more preferably at 1 to 40 vol%, further preferably at 2 to 35 vol%, further more preferably at 3 to 25 vol%, further more preferably at 5 to 25 vol% and particularly at 5 to 20 vol%. The thickness of the composite electroplated film may be selected as appropriate, and it is preferably at 1 to 5000 µm, more preferably at 3 to 2000 µm and further preferably at 5 to 1000 µm.

In the practice of the invention, means for changing the co-deposition amount of diamond particles in the metal matrix is not particularly limited. Specific means is exemplified below depending on the type of plating bath (or "plating solution"). One example of a preferred nickel plating bath composition for the invention is a bath containing 240 g/liter of nickel sulfate, 40 g/liter of nickel chloride and 35 g/liter of boric acid. As an example of suitable plating conditions for the invention, the plating bath temperature may be at 50°C, the pH at 4.2, and the current density at 0.1 to 8 A/dm², and the agitation rate may be varied within the range of 50 to 600 rpm. The diamond particles having an average particle size of 25 µm are dispersed in the plating solution in a range of its concentration at 1 to 150 g/liter. Varying the plating time within 10 to 1500 minutes, a composite electroplated film having a given thickness can be formed. As a more specific example, 50 g/liter of diamond particles having an average size of 25 µm are dispersed in the above-indicated nickel plating solution, and the agitation rate is gradually changed from 50 to 600 rpm while keeping the current density constant at 8 A/dm² so as to control the dispersion amount of the diamond particles in the solution. In these conditions, the co-deposition amount of the diamond particles in the resulting composite electroplated film gradually changes within the range of 0.5 to 26 vol% (0.3 to 11.5 wt%). In such way, for example, there can be formed a composite electroplated film having a total plated film thickness of 500 µm. Meanwhile, when plating is performed by dispersing diamond particles having an average size of 90 µm in an amount of 1 to 100 g/liter in the above-indicated nickel plating solution and gradually changing the agitation rate from 30 to 600 rpm, and also changing the current density from 1 to 8 A/dm², the co-deposition density of the diamond particles in the resulting composite electroplated film can be gradually changed within the range of 0.3 to 35 vol% (0.1 to 18 wt%). When plating is carried out by dispersing 1 to 100 g/liter of diamond particles having an average size of 3 µm in the above-indicated nickel plating solution, gradually changing the agitation rate from 30 to 600 rpm and also changing the current density from 1 to 8 A/dm², the co-deposition density of the diamond particles in the resulting composite electroplated film can be gradually changed within the range of 0.1 to 37 vol% (0.05 to 19 wt%).

On the other hand, a preferred example of a copper plating solution for the invention is a solution containing 220 g/liter of copper sulfate and 60 ml/liter of sulfuric acid. Suitable plating conditions include, for example, a plating bath temperature at 25°C and a current density at 0.1 to 10 A/dm² while the agitation rate is varied from 50 to 600 rpm. For example, when electroplating is carried out by dispersing 50 g/liter of diamond particles having an average size of 25 µm in the copper sulfate plating solution, and gradually changing the agitation rate from 50 to 600 rpm at a given current density of 4 A/dm² so as to control the dispersion amount of diamond particles in the solution, the co-deposition density of the diamond particles in the resulting composite electroplated film can be gradually changed within the range of 0.5 to 18 vol% (0.3 to 7 wt%). In such way, there can be formed a composite electroplated film having, for example, a total plated film thickness of 500 µm. Further, when plating is carried out by dispersing 1 to 100 g/liter of diamond particles having an average size of 90 µm in the above-indicated copper plating solution, and gradually changing the agitation rate of from 30 to 600 rpm and also changing the current density from 1 to 10 A/dm², the co-deposition density of the diamond particles in the resulting composite electroplated film can be gradually changed within the range of 0.3 to 23 vol% (0.1 to 12 wt%). When plating is carried out by dispersing 1 to 100 g/liter of diamond particles having an average size of 3 µm in the above-indicated copper plating solution, and gradually changing the agitation rate from 30 to 600 rpm and also changing the current density from 1 to 10 A/dm², the co-deposition density of the diamond particles in the resulting composite electroplated film can be gradually changed within the range of 0.1 to 25 vol% (0.05 to 13 wt%).

Next, the film configuration of the heat sink material of the invention is described in more detail. The heat sink material of the invention includes a composite electroplated film having a plated metal film as a matrix, and diamond particles co-deposited in the metal matrix in such a way that the co-deposition amount of the diamond particles in the metal matrix gradually changes relative to the thickness direction of the plated metal film. Here, the gradual change in the co-deposition amount (dispersion amount) of the diamond particles in the plated metal film matrix in the composite electroplated film of the invention means that the co-deposition amount may continuously increase or decrease, or may stepwisely increase or decrease. A composite electroplated film in which the co-deposition amount of the diamond particles is continuously changed relative to the thickness direction of the film is more preferable. In a film according to the invention, the co-deposition amount of the diamond particles gradually increases or decreases relative to the thickness direction in a single-layered plated film. Compared with the case of a laminate of two or more plated films having different co-deposition amounts of diamond particles, there is no lamination in the thickness direction of the film so that interfilm or interlayer separation would not occur, and thus excellent mechanical characteristics can be shown.

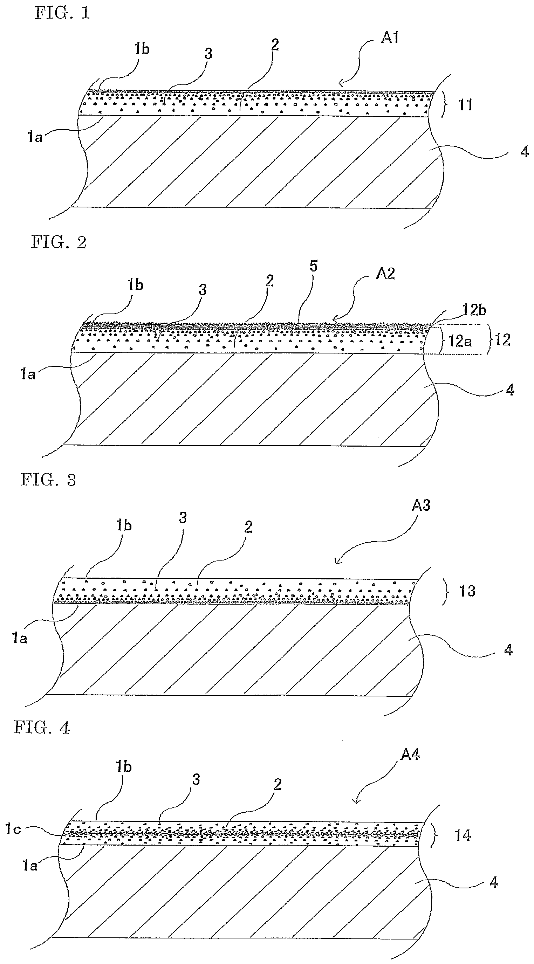

More specific configurations of the heat sink material of the invention are illustrated with reference to the drawings. Figs. 1, 2, 3 and 4 are each a schematic longitudinal sectional view of a portion of a heat sink material, respectively illustrating the first to the fourth configuration examples of the heat sink material of the invention. In these figures, A1, A2, A3 and A4 respectively indicate the heat sink materials; 11, 12, 13 and 14 each indicate the composite electroplated film; 2 indicates the plated metal film (metal matrix); 3 indicates diamond particles; 4 indicates the base substrate on which the composite electroplated film is formed; and 5 in Fig. 2 indicates the surface plated metal film. The first configuration example of the heat sink material of the invention is, as the heat sink material A1 shown in Fig. 1, such a plating configuration that the co-deposition amount (dispersion amount) of diamond particles 3 in the plated metal film 2 matrix gradually increases from a base substrate side 1a toward a film surface side 1b. According to such a configuration, there can be obtained a heat sink material that is excellent in thermal conductivity because of the physical characteristics of diamonds, specifically susceptibility to transmit thermal vibrations. Thus, an effect on heat sink properties is produced.

In such a plating configuration as in the first configuration example, it suffices so long as the co-deposition amount (dispersion amount) of the diamond particles 3 in the plated metal film 2 matrix gradually increases from the base substrate side 1a toward the film surface side 1b. The co-deposition amount at the boundary (base substrate side 1a) with the base substrate is preferably 0%. In cases where the diamond particles are gradually co-deposited, the co-deposition amount is increased gradually from 0.3 vol% and reaches at least 20 vol%, more preferably at least 35 vol%, in the vicinity of the film surface side 1b of the composite electroplated film. More specifically, the amount near the film surface side 1b is preferably at 10 to 50 vol%, more preferably at 15 to 40 vol% and further preferably at 15 to 35 vol%. Incidentally, in the case where the co-deposition amount of the diamond particles in the metal matrix changes as set forth above, if diamond particles whose average size is smaller than 25 µm are used, e.g., 3 µm as exemplified above, the filling rate of the diamond particles in the composite electroplated film increases, but on the other hand the strength of the plated film per se may become lower. Since it is desirable that thermal vibrations occur among diamond particles being in contact with one another, the diamond particles co-deposited in the composite electroplated film are preferably in a state of being in contact as much as possible. According to the invention, means for mutually contacting the diamond particles in the composite electroplated film is not particularly limited, and one example thereof is a method of controlling the agitation rate. More particularly, the degree of contact may be controlled by increasing contact by weak agitation and separating the particles by strong agitation. In such a plating configuration as in the first configuration, as stated above, the co-deposition amount of diamond particles are gradually increased so that the co-deposition amount becomes at least 20 vol%, preferably not less than 35 vol% in the vicinity of the surface side 1b of the composite electroplated film. This configuration allows the diamond particles to be more likely to mutually contact with one another particularly at the vicinity of the surface side 1b of the composite electroplated film. In the following second to fourth configuration examples, diamond particles are also likely to contact with one another by setting the co-deposition amount at the portion where the co-deposition amount of the diamond particles is increased as mentioned above, particularly at the portion where the co-deposition amount of the diamond particles is increased.

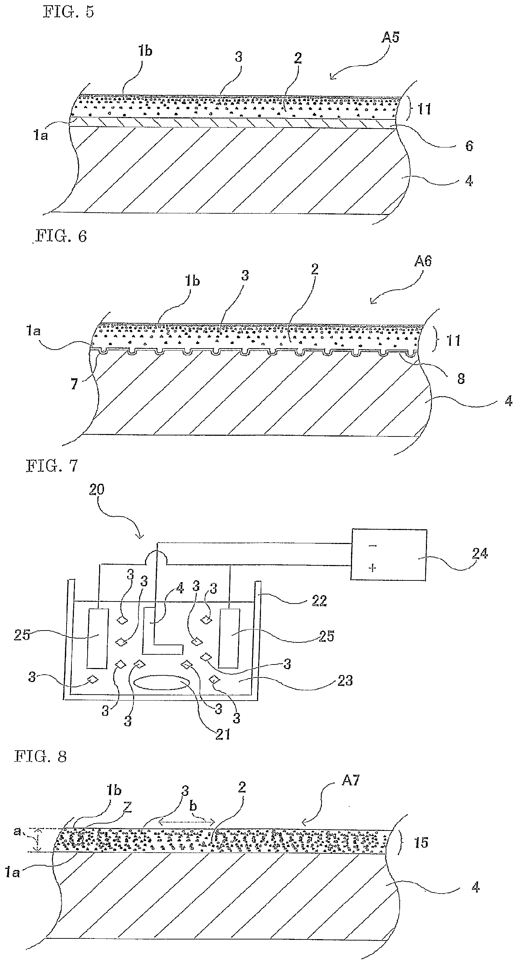

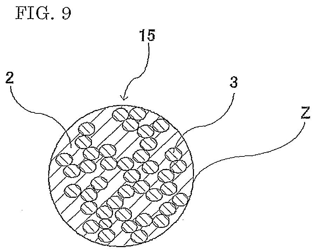

The co-deposition state in which diamond particles in the composite electroplated film are in contact with one another is described with reference to Figs. 8 and 9. Fig. 8 is a schematic longitudinal sectional view of a portion of a heat sink material A7 as a reference example for explaining the co-deposited state of mutually contacting diamond particles. Fig. 9 is an enlarged longitudinal sectional view of a portion of a composite electroplated film 15, showing the Z portion (a portion of the longitudinal section of the composite electroplated film 15) in Fig. 8 enlarged. The heat sink material A7 is provided, in place of the composite electroplated film 11 of the heat sink material A1 of the first configuration example, with the composite electroplated film 15 wherein the co-deposition amount (dispersion amount) of the diamond particles 3 in the plated metal film 2 matrix does not change from the base substrate side 1a toward the film surface side 1b. Viewing the plated metal film 2 as a whole, the diamond particles 3 are co-deposited uniformly in the thickness direction (indicated by the arrow a in Fig. 8) of the film and, as shown in Fig. 9, the diamond particles 3 mutually contact with one another in the matrix of the plated metal film 2 in the composite electroplated film 15. When the diamond particles 3 are co-deposited in the matrix in such a state, thermal vibrations occur among the mutually contacting diamond particles. As shown in the results of Experimental Examples 1 and 2 appearing hereinafter, compared with the case where diamond particles 3 are co-deposited in such a state that the particles are not in contact with one another in the matrix of the plated metal film 2, the heat sink properties can be more improved. In such a composite plated metal film 15, it is preferred that the diamond particles in the matrix of the plated metal film 2 are co-deposited in a co-deposition amount (dispersion amount) of at least 20 vol% relative to the total (total volume) of the composite plated metal film 15. This is in order to obtain a composite electroplated film wherein, when viewing the plated metal film 2 as a whole, the diamond particles 3 are dispersed uniformly in the thickness direction of the film, but the diamond particles mutually contact with one another in at least a part of the matrix of the plated metal film 2.

In the composite electroplated film of the invention, the contact form is not particularly limited in the co-deposition state where the diamond particles mutually contact with one another in the matrix. For instance, observing a longitudinal section of the film, there may be formed a co-deposition portion where the diamond particles mutually and continuously contact with one another only in the thickness direction of the film (indicated by arrow a in Fig. 8), i.e., in the height direction of the film, or there may be a co-deposition state where only adjoining diamond particles in the lateral direction of the film (indicated by arrow b in Fig. 8), i.e., in the horizontal or width direction of the film as viewed in the sectional view, contact with one another continuously in an appropriate length. Referring to the reference example of Fig. 9, it is preferable that the diamond particles are co-deposited in a state wherein the particles, at some portions, mutually contact with one another continuously both in the thickness direction of the film (indicated by arrow a in Fig. 8) and in the width direction of the film (indicated by arrow b in Fig. 8). The ratio of the contact portion is not particularly limited. The ratio of contacting diamond particles can be measured by cutting the heat sink material having the composite electroplated film thereon along the longitudinal direction, i.e., along the thickness direction, and observing the film configuration of all or part of the cut surface using a microscope such as an electron microscope. When observation by image processing or the like is carried out to find the ratio of diamond particles contacting mutually and continuously with one another in the thickness and/or width direction of the film in the metal matrix, the area ratio to the entire observed area is preferably at 5 to 80%, more preferably at 15 to 60% and further preferably at 20 to 45%. If the ratio of the mutually contacting area is too small, an effect produced by the mutual contact of diamond particles may be difficult to be obtained. If the ratio of the contact area is too large, it may be difficult to obtain the favorable characteristics as a composite electroplated film. The contact state of diamond particles as set forth above also can be applied to the following second to fourth configuration examples.

The second configuration example of the invention is, as the heat sink material A2 shown in Fig. 2, such that diamond particles 3 are exposed at a film surface 12b of a diamond co-deposited film 12a wherein the co-deposition amount (dispersion amount) of diamond particles 3 in the matrix of a plated metal film 2 gradually increases from a base substrate side 1a toward a film surface side 1b as with the first configuration example. The metal surface at which the diamond particles are exposed is further plated with a metal different from the metal forming the plated metal film of the composite electroplated film. The metal for the surface is preferably copper, gold, silver, iron or the like, more preferably gold, silver or the like, and by forming a plated surface metal film 5 a composite electroplated film 12 can be composed. As a combination of the metal source forming the plated metal film 2 and the metal source forming the plated surface metal film 5, it is preferable to combine as appropriate the preferred metal sources indicated hereinabove. Particularly suitable combinations include a combination of nickel as the metal source for the plated metal film 2 and gold as the metal source for the plated surface metal film 5, and a combination of copper as the metal source for the plated metal film 2 and silver as the metal source for the plated surface metal film 5.

The thickness of the plated surface metal film 5 is not particularly limited. When taking the particle size of diamond particles into account, the thickness is preferably not larger than 4/5 of the average size of the diamond particles 3, more preferably 1/2 to 1/3 of the average size of the diamond particles 3. Moreover, since it is further preferable that part of the diamond particles 3 is exposed on the surface of the plated surface metal film 5 in the second configuration example, it is more suitable if the thickness is not larger than 4/5 of the average size of the exposed diamond particles on the film surface of the diamond co-deposited film 12a, and more preferably 1/2 to 1/3 of the average size of the exposed diamond particles. The method of exposing the diamond particles 3 at the film surface 12b of the diamond co-deposited film 12a is not particularly limited: for example, co-deposition at a concentration of at least 20 vol% is suitable.

The third configuration example of the invention has, as the heat sink material A3 shown in Fig. 3, a plating configuration in which the co-deposition amount (dispersion amount) of diamond particles 3 in the matrix of a plated metal film 2 gradually decreases from a base substrate side 1a toward a composite electroplated film surface side 1b. According to this configuration, there can be obtained a heat sink material that is excellent in thermal conductivity especially owing to the susceptibility to transmit thermal vibrations among the physical characteristics of diamonds. Thus, a heat sink effect can be produced as with the heat sink material A1.

With the plating configuration of this third configuration example, it suffices so long as the co-deposition amount (dispersion amount) of the diamond particles 3 in the matrix of the plated metal film 2 gradually decreases from the base substrate side 1a toward the composite electroplated film surface side 1b. The co-deposition amount at a boundary portion (base substrate side 1a) with the base substrate is preferably at 10 to 50 vol%, more preferably at 15 to 40 vol% and further preferably at 15 to 35 vol%. When the co-deposition amount of diamond particles gradually decreases, it is preferred that the co-deposition amount of diamond particles is made substantially at 0 vol% in the vicinity of the surface on the opposite side. The appearance of the heat sink material A3 configured in such a way when viewed from the surface thereof can be rich in smoothness and gloss like ordinary plated metal surfaces.

The fourth configuration example of the heat sink material of the invention has, as the heat sink material A4 shown in Fig. 4, such a plating configuration that the co-deposition amount (dispersion amount) of diamond particles 3 in the matrix of a plated metal film 2 gradually increases from a base substrate side 1a toward an intermediate portion 1c in the thickness direction of a composite electroplated film and gradually decreases from the intermediate portion 1c toward a film surface side 1b of the composite electroplated film. Such a configuration has a sectional structure wherein the diamond particles increase their filling density toward the center of the composite electroplated film layer, and it may be said to be a functionally graded material (FGM, inhomogeneous dispersion system) that excels in strength as well.

With the plating configuration as in the fourth configuration example, it suffices so long as the co-deposition amount (dispersion amount) of the diamond particles in the matrix of the plated metal film gradually increases from the base substrate side 1a toward the intermediate portion 1c in the thickness direction of the composite electroplated film, and gradually decreases from the intermediate portion 1c toward the surface side 1b of the composite electroplated film. More preferably, the co-deposition amount at a boundary portion (base side 1a) with the base substrate is at 0%, the co-deposition amount at the intermediate portion in the thickness direction of the composite electroplated film is at 10 to 50 vol%, further preferably at 15 to 40 vol% and further more preferably at 15 to 35 vol%, and the co-deposition amount at the surface side 1b of the composite electroplated film is at 0%.

The heat sink material of the invention may be formed of a laminate in which an appropriate type of film is stacked on the above stated composite electroplated film. For instance, as the heat sink material A5 of the fifth configuration example of the invention shown in Fig. 5, a plated metal film 6 may be interposed between a composite electroplated film 11 and a base substrate 4 arranged as in the first configuration example. Such a configuration example may be composed by forming, on the base substrate 4, a plated metal film 6 made from a metal source that is different in type from the metal source for the plated metal film 2, e.g., copper, and further forming a composite electroplated film 11 increasing the filling density ratio of diamond particles 3 gradually from a base substrate side 1a toward a film surface side 1b. The plated metal film 6 is preferably a plated metal film that transmits thermal vibrations from the base substrate well. Such a plated metal film includes a plated copper film and a plated silver film, of which the plated copper film is preferred. If the base substrate is made of an electrically non-conductive material such as a plastic or glass material, as described hereinafter, a conductive thin film may be formed over the surface thereof and the conductive thin film surface may be subsequently followed by copper plating or nickel plating as mentioned above, and then a composite electroplated film may be formed wherein the co-deposition amount of diamond particles gradually increases from the base substrate side 1a toward the film surface side 1b.

Further, the heat sink material of the invention may be a laminate having another plated metal film over the above stated composite electroplated film including the plated metal film interposed in between with the base substrate. According to this configuration, if the appearance of the heat sink material is required as a functionally graded plated film, blackening treatment may be applied after copper plating or nickel plating other than noble metal plating such as silver plating or gold plating.

In the case of such a plating configuration, the configuration of the composite electroplated film is not specifically limited. For instance, taking mechanical strength into consideration, if the metal matrix of the composite electroplated film is made of a hard metal, the plated metal film interposed in between with the base substrate preferably is, for example, a nickel film. The thickness of the plated nickel film is preferably at about 1/4 to 1/3 of the thickness of the composite electroplated film. On the other hand, if the metal matrix of the composite electroplated film is made of a soft metal, the plated metal film interposed in between with the base substrate is preferably a copper or silver film. The thickness of the plated metal film formed of these metals is preferably at about 1/4 to 1/3 of the composite electroplated film.

The heat sink material of the invention makes it easier to form such a composite electroplated film over a molded article, as a base substrate, made of a variety of materials. For example, molded metal articles made of iron, aluminum, copper and alloys thereof can be used as the base substrate.

The heat sink material of the invention can employ, as a base substrate, molded glass or plastic articles. When using these non-metal materials as a base substrate, there can be obtained a heat sink material that is excellent in weight saving and easiness of moldability. Specific examples of the plastic material include commodity plastics such as ABS (acrylonitrile/ butadiene/styrene) resins, PC (polycarbonate) resins, PC/ABS resins, nylon resins, and modified PPO (Noryl resins); and engineering plastics and super engineering plastics. Examples of a molded glass article include oxide glass, particularly, silicate glass, phosphate glass, borate glass and the like. For the heat sink material of the invention, since the composite plating is carried out by electroplating, it is preferred to use, as a base substrate, a molded plastic or glass article made of a plastic or glass material having heat resistant up to a normal temperature to about 70°C.

When a molded glass or plastic article is used as a base substrate, it is preferred to apply surface treatment on the base substrate prior to the formation of a composite electroplated film. For instance, a surface treatment of adsorbing a metal, such as palladium (Pd), on the surface of the base substrate may be carried out. More particularly, as the heat sink material A6 of the sixth configuration example of the invention shown in Fig. 6, concave part 7 may be formed on the surface of a base substrate 4, followed by formation of a Pd adsorption layer 8. In this configuration example, such a composite electroplated film 11 as that in the first configuration example is formed on the Pd adsorption layer 8. As a specific method of this surface treatment, known methods may be appropriately adopted. For example, the surface of the molded article may be chemically roughened (made rough surface) by means of an etchant. After removal of the remaining etching solution, palladium is adsorbed by use of a Pd-Sn complex, and by removing the resulting Sn salt and metallizing of palladium, the Pd adsorption layer is formed.

In the heat sink material of the invention, there may be used, as a base substrate, molded ceramic articles made of various types of ceramics used in electronic materials other than glass. Examples of the molded ceramics include alumina ceramics, silicon carbide ceramics, zinc oxide ceramics, vanadium titanate ceramic, and zirconium ceramics. These molded ceramic articles may also be subjected to the treatment set forth above to provide materials having excellent heat sink properties. In this case as well, it is preferred that the molded ceramic article is surface-treated and then a composite electroplated film is formed.

In the practice of the invention, an apparatus for forming the above-stated composite electroplated film is not particularly limited in type. One preferred apparatus is an electroplating apparatus 20 shown in Fig. 7. The electroplating apparatus 20 of Fig. 7 includes a plating vessel 22 provided with an agitator 21. It fills a certain type of plating solution 23 in which diamond particles 3 are dispersed, and immerses anode materials 25 connected to the anode of a DC power supply 24 and the base substrate 4 connected to the cathode of the DC electric power supply 24 into the plating solution, thereby forming a composite electroplated film on the surface of the base substrate 4.

The heat sink material of the invention has a great degree of freedom in selecting the shape of the base substrate and even when using, as a base substrate, a molded article having a complicated shape with a number of rough surface, it is possible to readily form a composite electroplated film thereon. The heat sink material of the invention can make use, as a base substrate, of a metal base substrate of a metal such as aluminum, copper, or brass, or a non-metal base substrate of a material such as a plastic, glass or ceramic material as indicated above. In addition, a composite electroplated film that is unlikely to peel off can be formed. More particularly, the composite electroplated film may be formed not only on a heat sink plate using a plate member as a base substrate, but also on an inner or outer wall of a tubular base substrate in the form of a cylinder, an angular tube or the like.

Here when a composition of a base substrate covered with a composite electroplated film co-deposited with diamond particles is used as a heat sink material, it is preferred that the thermal conductivity of the composite electroplated film is improved so as to improve the heat sink properties of the composite electroplated film. The heat sink material of the invention has a gradual change in co-deposition amount of diamond particles in the plated metal film in the thickness direction of the plated metal film. Thus, it has improved heat sink properties over a composite electroplated film wherein the co-deposition amount of diamond particles in a plated metal film is not changed, as will be seen from the results of Examples and Experimental Examples appearing hereinafter. For instance, when a heat sink material having desired heat sink properties is to be obtained, it becomes possible to decrease the total co-deposition amount of diamond particles in the plated metal film, i.e., the co-deposition amount throughout the film, compared to the case where the co-deposition amount of diamond particles in a plated metal film does not change in the thickness direction. Although physical properties of the heat sink material of the invention are not specifically limited, when taking the function as a heat sink material into consideration, it is preferred that the thermal conductivity of the heat sink material of the invention except for the base substrate is at a certain level. For instance, with a composite electroplated film using copper as a metal source for forming the plated metal film, when the thermal conductivity after removal of the substrate as in Examples appearing hereinafter is measured, it is preferred that an average value of the resulting measurements at three points excluding the lowest and highest values of five-point measurement is at 300 to 750 W/mk. When using a composite electroplated film using nickel as a metal source, such an average value of thermal conductivity as indicated above is preferably at 100 to 200 W/mk.

In the heat sink material of the invention, substrates of a variety of shapes made of various types of materials are used, on which a composite electroplated film having a graded function is formed. For instance, the heat sink material may be used as a heat sink plate interposed between a heat-generating portion and other portion of an electronic part or a semiconductor device, a heat sink plate used as a heat exchanging part, a heat sink, a heat sink plate for heat sink fins or flat screen televisions, heat sink chassis or frames, a heat sink plate or heat sink for power modules, a heat sink plate of optical devices such as light-emitting diodes (LEDs) and the like, and a radiator for engines. It is also preferable to be used as a heat sink plate for cell phones and a heat sink plate for personal computers. Especially, the present invention enables the heat sink material itself to be thinned down and reduced in weight.

The invention should not be construed to be limited to the configurations set forth hereinabove, and may be altered in various ways without deviating from the scope of the invention.

### EXAMPLES

Examples are shown to particularly illustrate the invention; however it should not be construed as limited to the following examples.

### [Example 1]

Using the electroplating apparatus of Fig. 7 (anode material: electrolytic nickel plate) and a stainless steel sheet (20 mm × 20 mm × 0.5 mm) as a base substrate, there was obtained a heat sink material of Example 1 according to the following operation procedure.

### <Operation procedure>

Diamond particles having an average particle size of 25 µm, made by Element Six Co., Ltd., were dispersed in a nickel plating solution made of a composition indicated in the following Table 1 in a dispersion amount of 50 g/liter. Under a current density at 8 A/dm² and a plating time at 300 minutes, there was obtained a composite electroplated film having a given total plated film thickness of 500 µm. In the course of the formation of the composite electroplated film, an agitation rate was gradually changed from 500 rpm to 150 rpm to form. Thus, on the substrate surface, a functionally graded film (composite electroplated film) wherein the co-deposition density of the diamond particles gradually increased from 0 vol% to 35 vol% from the substrate surface side toward the film surface side was formed, thereby obtaining the heat sink material of Example 1. This heat sink material was cut along a longitudinal direction, or along a film thickness direction and the section (the longitudinal section of the film) was observed through an electronic microscope, revealing mutual contact of the diamond particles in the thickness direction of the film (or in the height direction of the film) and also in the width direction of the film (or in the lateral direction of the film). When the contact state was observed and confirmed by image processing, it was revealed that the diamond particles contacted with one another at a portion of about 1/5 (about 20%) of the entire composite electroplated film in terms of area ratio. In order to evaluate the thermal conductivity of the functionally graded film (composite electroplated film) of Example 1 (as well in the following examples), the heat sink material was separated from the base substrate and its thermal conductivity was measured by use of a thermal conductivity measuring device (Model TC-7000, made by ULVAC Inc.) at room temperature of 22 to 24°C at a humidity of 38 to 45%. The results are also shown in Table 1. It is noted that in the following tables, an average value is an average value of measurements at three points excluding the lowest and highest values of five-point measurement. To evaluate a heat sink state of the heat sink material of Example 1 (as well in the following examples), an infrared thermographic device (FSV-1100-L8, made by Apiste Corporation) was used to measure a time until the heat sink material of Example 1 arrived at a given temperature indicated in Table 1 under conditions of a heater temperature at 210°C, a room temperature at 21 to 25°C and a humidity at 35 to 41%. The results are also shown in Table 1.

**[Table 1]**

| Nickel plating bath composition | Results of measurement of thermal conductivity (W/mk) | Results of measurement of infrared thermography | |
|---|---|---|---|
| Nickel sulfate 240 g/liter | Five-point measurement | Given temperature (°C) | 195 |
| Nickel chloride 40 g/liter | 206, 86, 184, 132, 187 | Arrival time (seconds) | 238 |
| Boric acid 35 g/liter | | | |
| pH 4.2 | Average value | | |
| Temperature 50°C | 168 | | |

### [Example 2]

Using an electroplating device (anode material: electrolytic copper plate) shown in Fig. 7 and a stainless steel sheet (20 mm × 20 mm × 0.5 mm) as a base substrate, there was obtained a heat sink material of Example 2 according to the following operation procedure.

### <Operation procedure>

Diamond particles having an average particle size of 25 µm, made by Element Six Co., Ltd., were dispersed in a copper plating solution made of a composition indicated in the following Table 2 in a dispersion amount of 50 g/liter. Under a current density at 0.1 to 6 A/dm² and a plating time at 540 minutes, there was obtained a composite electroplated film having a given total plated film thickness of 500 µm. In the course of the formation of the composite electroplated film, an agitation rate was gradually changed from 600 rpm to 50 rpm to form, on the substrate surface, a functionally graded film (composite electroplated film), in which the co-deposition density of the diamond particles gradually increased from 0 vol% to 25 vol% from the substrate surface side toward the film surface side, thereby obtaining the heat sink material of Example 2. This heat sink material was observed in the same way as in Example 1, revealing the mutual contact of the diamond particles in the thickness and width directions of the film at portions of about 1/4 (about 25%) of the entire composite electroplated film (by area ratio). The base substrate was removed from the heat sink material to measure the thermal conductivity thereof by use of a thermal conductivity measuring device (Model TC-7000, made by ULVAC Inc.) at room temperature of 22 to 24°C at a humidity of 38 to 45%. The results are also shown in Table 2. Using an infrared thermographic device (FSV-1100-L8, made by Apiste Corporation), there was measured a time until the heat sink material of Example 2 arrived at a given temperature indicated in Table 2 under conditions of a heater temperature at 210°C, a room temperature at 21 to 25°C and a humidity at 35 to 41%. The results are also shown in Table 2.

**[Table 2]**

| Copper plating bath composition | Results of measurement of thermal conductivity (W/mk) | Results of measurement of infrared thermography | |
|---|---|---|---|
| Copper sulfate 240 g/liter | Five-point measurement | Given temperature (°C) | 197 |
| Sulfuric acid 60 g/liter | 560, 618, 622, 706, 783 | Arrival time (seconds) | 138 |
| Temperature 25°C | | | |
| | Average value | | |
| | 648 | | |

### [Example 3]

Using an electroplating device (anode material: electrolytic nickel plate) shown in Fig. 7 and a stainless steel sheet (20 mm × 20 mm × 0.5 mm) as a base substrate, there was obtained a heat sink material of Example 3 according to the following operation procedure.

### <Operation procedure>

Diamond particles having an average particle size of 25 µm, made by Element Six Co., Ltd., were dispersed in a nickel plating solution made of a composition indicated in the following Table 3 in a dispersion amount of 50 g/liter. Under a current density at 8 A/dm² and a plating time at 290 minutes, there was obtained a composite electroplated film having a given total plated film thickness of 490 µm. In the course of the formation of the composite electroplated film, an agitation rate was gradually changed from 500 rpm to 150 rpm to form, on the substrate surface, a functionally graded film (diamond co-deposited film), in which the co-deposition density of the diamond particles gradually increased from 0 vol% to 35 vol% from the substrate surface side toward the film surface side. Next, copper plating was performed by use of a copper plating bath made of a composition indicated in the following Table 3 under a current density at 2 A/dm² and a plating time at 20 minutes to form a plated surface copper film having a given film thickness of 10 µm among the diamond particles exposed from the functionally graded film (diamond co-deposited film) thereby obtaining the heat sink material of Example 3. As to the total plated film thickness, a given thickness of 500 µm was attained. This heat sink material was observed in the same manner as in Example 1, revealing that diamond particles mutually contacted with one another in the thickness and width directions of the film at portions of about 1/4 (about 25%) of the entire composite plated film (by area ratio). The base substrate was removed from the heat sink material of Example 3 to measure the thermal conductivity thereof in the same manner as in Example 1. A time until the heat sink material of Example 3 arrived at a given temperature indicated in Table 3 was measured in the same manner as in Example 1. The results are also shown in Table 3.

**[Table 3]**

| Nickel plating bath composition | Results of measurement of thermal conductivity (W/mk) | Results of measurement of infrared thermography | |
|---|---|---|---|
| Nickel sulfate 240 g/liter | Five-point measurement | Given temperature (°C) | 198 |
| Nickel chloride 40 g/liter | 131, 90, 184, 178, 290 | Arrival time (seconds) | 241 |
| Boric acid 35 g/liter | | | |
| pH 4.2 | Average value | | |
| Temperature 50°C | 164 | | |
| | | | |
| Copper plating bath composition | | | |
| Copper sulfate 240 g/liter | | | |
| Sulfuric acid 60 g/liter | | | |
| Temperature 25°C | | | |

### [Example 4]

Using an electroplating device (anode material: electrolytic nickel plate) shown in Fig. 7 and a stainless steel sheet (20 mm × 20 mm × 0.5 mm) as a base substrate, there was obtained a heat sink material of Example 4 according to the following operation procedure.

### <Operation procedure>

Diamond particles having an average particle size of 25 µm, made by Element Six Co., Ltd., were dispersed in a nickel plating solution made of a composition indicated in the following Table 4 in a dispersion amount of 50 g/liter. Under a current density at 8 A/dm² and a plating time at 300 minutes, there was obtained a composite electroplated film having a given total plated film thickness of 500 µm. In the course of the formation of the composite electroplated film, an agitation rate was gradually changed from 150 rpm to 500 rpm to form, on the substrate surface, a functionally graded film (composite electroplated film), in which the co-deposition density of the diamond particles gradually decreased from 35 vol% to 0 vol% from the substrate surface side toward the film surface side thereby obtaining the heat sink material of Example 4. This heat sink material was observed in the same manner as in Example 1, revealing that diamond particles mutually contacted with one another in the thickness and width directions of the film at portions of about 1/4 (about 25%) of the entire composite plated film (by area ratio). The base substrate was removed from the heat sink material of Example 4 to measure the thermal conductivity thereof in the same manner as in Example 1. A time until the heat sink material of Example 4 arrived at a given temperature indicated in Table 4 was measured in the same manner as in Example 1. The results are also shown in Table 4.

**[Table 4]**

| Nickel plating bath composition | Results of measurement of thermal conductivity (W/mk) | Results of measurement of infrared thermography | |
|---|---|---|---|
| Nickel sulfate 240 g/liter | Five-point measurement | Given temperature (°C) | 196 |
| Nickel chloride 40 g/liter | 80, 282, 126, 132, 178 | Arrival time (seconds) | 259 |
| Boric acid 35 g/liter | | | |
| pH 4.2 | Average value | | |
| Temperature 50°C | 145 | | |

### [Example 5]

Using an electroplating device (anode material: electrolytic nickel plate) shown in Fig. 7 and a stainless steel sheet (20 mm × 20 mm × 0.5 mm) as a base substrate, there was obtained a heat sink material of Example 5 according to the following operation procedure.

### <Operation procedure>

Diamond particles having an average particle size of 25 µm, made by Element Six Co., Ltd., were dispersed in a nickel plating solution made of a composition indicated in the following Table 5 in a dispersion amount of 50 g/liter. Under a current density at 8 A/dm² and a plating time at 300 minutes, there was obtained a composite electroplated film having a given total plated film thickness of 500 µm. In the course of the formation of the composite electroplated film, an agitation rate was gradually changed from 500 rpm to 150 rpm, at which the rate was then gradually changed again to 500 rpm to form, on the substrate surface, a functionally graded film (composite electroplated film), in which the co-deposition density of the diamond particles gradually increased from 0 vol% to 35 vol% from the substrate surface side toward an intermediate portion of the film and gradually changed from 35 vol% to 0 vol% from the intermediate portion toward the substrate surface side, thereby obtaining the heat sink material of Example 5. This heat sink material was observed in the same manner as in Example 1, revealing that diamond particles mutually contacted with one another in the thickness and width directions of the film at portions of about 1/5 (about 20%) of the entire composite plated film (by area ratio). The base substrate was removed from the heat sink material of Example 5 to measure the thermal conductivity thereof in the same manner as in Example 1. A time until the heat sink material of Example 5 arrived at a given temperature indicated in Table 5 was measured in the same manner as in Example 1. The results are also shown in Table 5.

**[Table 5]**

| Nickel plating bath composition | Results of measurement of thermal conductivity (W/mk) | Results of measurement of infrared thermography | |
|---|---|---|---|
| Nickel sulfate 240 g/liter | Five-point measurement | Given temperature (°C) | 192 |
| Nickel chloride 40 g/liter | 40, 201, 90, 104, 114 | Arrival time (seconds) | 276 |
| Boric acid 35 g/liter | | | |
| pH 4.2 | Average value | | |
| Temperature 50°C | 104 | | |

### [Comparative Examples 1 and 2]

A plated nickel film having a plated film thickness of 500 µm was formed on such a substrate as used in Example 1, without dispersing diamond particles in a nickel plating solution, under a current density at 8 A/dm², a constant agitation rate at 400 rpm and a plating time at 310 minutes thereby providing a heat sink material of Comparative Example 1. Moreover, in the same manner as in Example 2 without dispersing the diamond particles in the copper plating solution and a current density was set at 4 A/dm², an agitation rate was constant at 400 rpm and a plating time was at 530 minutes, there was formed a plated copper film having a plated film thickness of 500 µm on such a base substrate as in Example 1 thereby providing a heat sink material of Comparative Example 2. The base substrate was removed from the heat sink materials of Comparative Examples 1 and 2, respectively, followed by measurement of thermal conductivity in the same manner as in Example 1. A time until the heat sink materials of Comparative Examples 1 and 2 arrived at a given temperature indicated in Table 6 was measured in the same manner as in Example 1. The results are also shown in Table 6.

**[Table 6]**

| | Results of measurement of thermal conductivity (W/mk) | | Results of measurement of infrared thermography | |
|---|---|---|---|---|
| Comparative Example 1 | Five-point measurement | Average value | Given temperature (°C) | 78 |
| | 89, 77, 83, 94, 98 | 89 | Arrival time (seconds) | 660 |
| Comparative Example 2 | Five-point measurement | Average value | Given temperature (°C) | 85 |
| | 361, 387, 388, 392, 376 | 384 | Arrival time (seconds) | 540 |

### [Experimental Example 1, 2]

Using an electroplating device (anode material: electrolytic nickel plate) shown in Fig. 7 and a stainless steel sheet (20 mm × 20 mm × 0.5 mm) as a base substrate, there were obtained heat sink materials of Experimental Examples 1 and 2 according to the following operation procedures.

### <Operation procedures>

In the same manner as in Example 1 except that the agitation rate was constant at 300 rpm, the plating time was at 270 minutes and diamond particles having an average size of 25 µm were dispersed in a nickel plating solution in a dispersion amount of 100 g/liter, there was obtained a heat sink material of Experimental Example 1 including a composite electroplated film having a film thickness of 500 µm formed on a substrate surface, in which the co-deposition density of the diamond particles were constant at 30 vol% (i.e. a co-deposition amount throughout the film was at 30 vol%) and had no change from the substrate surface side toward the film surface side. This heat sink material was observed in the same manner as in Example 1, revealing that diamond particles mutually contacted with one another in the thickness direction (height direction) and width direction (lateral direction) of the film at portions of about 1/5 (about 20%) of the entire composite plated film (by area ratio). A time until the base substrate of the heat sink material of Experimental Example 1 arrived at a given temperature (195°C) was measured in the same manner as in Example 1, revealing that the arrival time was at 238 seconds. Next, in the same manner as in Experimental Example 1 except that the agitation rate was constant at 500 rpm, there was obtained a heat sink material of Experimental Example 2 including a composite electroplated film having a film thickness of 500 µm, in which the co-deposition density of diamond particles was constant at 35 vol% (i.e. a co-deposition density throughout the film as at 35 vol%) and thus, did not change from the substrate surface side toward the film surface side. This heat sink material was observed in the same manner as in Example 1, revealing no mutual contact of diamond particles. A time until the base substrate of the heat sink material of Experimental Example 2 arrived at a given temperature (193°C) was measured in the same manner as in Example 1, revealing that the arrival time was at 256 seconds.

According to the results of the measurement of the arrival time arriving at a given temperature with respect to the heat sink materials of Examples 1, 4, and 5 and Experimental Examples 1 and 2, it was confirmed that the heat sink materials of Examples 1, 4 and 5 including, as a composite electroplated film wherein the diamond particles were co-deposited in the plated metal film, a functionally graded film wherein the co-deposition amount of the diamond particles gradually changed between 0 and 35 vol% toward the film thickness direction (a co-deposition amount throughout the film, i.e. a total co-deposition amount, was at 17.5 vol%) showed substantially the same thermal conductivity even when the total co-deposition amount (i.e. a co-deposition amount throughout the film) is about a half in the composite electroplated film wherein the co-deposition amount of diamond particles does not change along the film thickness. In view of these results, since the co-deposition amount of the diamond particles in the plated metal film gradually changes in the thickness direction of the plated metal film, the heat sink materials of Examples 1, 4, and 5 show much more excellent thermal conductivity than those of a composite electroplated film whose co-deposition amount of diamond particles does not change in the thickness direction of a plated metal film. Thus, it will be seen that the heat sink properties are improved owing to the composite electroplated film co-deposited with diamond particles therein. It will be noted that when comparing the results of Experimental Examples 1 and 2, when diamond particles are co-deposited in mutual contact with one another in the composite electroplated film wherein the diamond particles are co-deposited in the plated metal film, higher thermal conductivity is obtained over the case wherein diamond particles are co-deposited without mutual contact thereof, thereby improving heat sink properties.

### INDUSTRIAL APPLICABILITY

The heat sink material of the invention has utility in various fields of car electronics, information home electronics, industrial equipment, biotechnology, medical services, motor sports, aerospace, communication devices, transmission sites and the like. The material can be used as a heat sink substrate for power transistor, a heat sink substrate for LED, a driver substrate for control, a substrate for power supply, and thermal diffusion plates therefor. The material can also be used in parts such as of head lamps, illumination devices, car navigators, personal computers, projectors, DVD, air conditioners, cell phones, displays, and heat sinks for vehicles.

### DESCRIPTION OF REFERENCE SYMBOLS

A1 to A7: Heat sink material
11, 12, 13, 14, 15: Composite electroplated film
12a: Co-deposited diamond film
12b: Film surface (of co-deposited diamond)
2: Plated metal film (metal matrix)
3: Diamond particles
4: Base substrate
5, 6: Plated surface metal film
a: Film thickness direction
b: Lateral direction of film

## Claims

1. A heat sink material (A1; A2; A3; A5) comprising a base substrate (4) and a composite electroplated film (11; 12; 13) formed on a side thereof, said composite electroplated film (11; 12; 13) including a plated metal film (2)as a matrix and diamond particles (3) that are co-deposited in said matrix in such a way that a co-deposition amount thereof gradually changes in a thickness direction of said plated metal film (2), wherein an average particle size of said diamond particles (3) is 1 to 250 µm when determined by a laser diffraction-type particle size distribution measuring method and the composite electroplated film (11; 12; 13) is configured either (A) so
that a co-deposition amount of said diamond particles (3) in said matrix (2) gradually increases from the base substrate side (1a), on which said composite electroplated film (11; 12; 13) is formed, toward a film surface side (1b); or (B) so that a co-deposition amount of said diamond particles (3) in said matrix (2) gradually decreases from the base substrate side (1a) toward the film surface side (1b).

2. The heat sink material (A1; A2; A3; A5) as defined in claim 1, wherein said diamond particles (3) mutually contact with one another at at least a part of said plated metal film (2).

3. The heat sink material (A1; A2; A3; A5) as defined in claim 2, wherein the area ratio of contacting diamond particles (3) to the entire observed area is at 15 to 60% as determined by image processing of a thickness direction section of said plated metal film (2) .

4. The heat sink material (A1; A2; A3; A5) as defined in any one of claims 1 to 3, wherein said composite electroplated film (11; 12; 13) is so configured that a co-deposition amount of said diamond particles (3) in said matrix (2) gradually increases from the base substrate side (1a) toward the film surface side (1b) and is provided, on the surface (12b) of the diamond co-deposited film (12a) at which said diamond particles (3) are exposed to a surface thereof, with a plated surface metal film (5) formed from a metal source different from a metal source used to form said matrix plated metal film (2).

5. The heat sink material (A1; A2; A3; A5) as defined in claim 4, wherein said plated surface metal film (5) has a thickness of 1/2 to 1/3 of an average particle size of said diamond particles (3).

6. The heat sink material (A1; A2; A3; A5) as defined in claim 4 or 5, wherein the metal source used to form said plated surface metal film (5) is copper, silver, gold or iron.

7. The heat sink material (A1; A2; A3; A5) as defined in any one of claims 1 to 6, wherein a thickness of said composite electroplated film (11; 12; 13) is at 1 to 5000 µm.

8. The heat sink material (A1; A2; A3; A5) as defined in any one of claims 1 to 7, wherein the metal source for forming said matrix plated metal film (2) consists of one or two or more selected from copper, nickel, gold, silver, tin, cobalt, iron, zinc and chromium.

9. The heat sink material (A1; A2; A3; A5) as defined in any one of claims 1 to 8, wherein a molded glass article is used as the base substrate (4).

10. The heat sink material (A1; A2; A3; A5) as defined in any one of claims 1 to 8, wherein a molded plastic article is used as the base substrate (4).

11. The heat sink material (A1; A2; A3; A5) as defined in any one of claims 1 to 10, wherein a plated metal film (6) formed from a metal source different from a metal source used to form said matrix plated metal film (2) is interposed between said composite electroplated film (11; 12; 13) and said base substrate (4).

12. The heat sink material (A1; A2; A3; A5) as defined in claim 11, wherein the thickness of said interposed plated metal film (6) is at 1/4 to 1/3 of the thickness of said composite electroplated film (11; 12; 13).

13. Use of the heat sink material (A1; A2; A3; A5) as defined in any one of claims 1 to 12, as a heat sink material for a semiconductor device.

14. Use as defined in claim 13, wherein use is made as a heat sink material for a cell phone or a personal computer.

15. Use of the heat sink material (A1; A2; A3; A5) as defined in any one of claims 1 to 12 as a heat sink material for an optical device.

## Patentansprüche

1. Kühlkörpermaterial (A1; A2; A3; A5), umfassend ein Basissubstrat (4) und einen elektroplattierten Verbund-Film (11; 12; 13), der auf einer Seite desselben ausgebildet ist, wobei der elektroplattierte Verbund-Film (11; 12; 13) einen plattierten Metallfilm (2) als eine Matrix und Diamantpartikel (3), die in der Matrix derart gleichzeitig abgeschieden werden, dass sich eine gleichzeitiges Abscheidungsausmaß derselben allmählich in eine Dickenrichtung des plattierten Metallfilms (2) ändert, umfasst, wobei eine durchschnittliche Partikelgröße der Diamantpartikel (3) bei Bestimmung durch ein Laserbeugungsttyp-Partikelgrößenverteilungsmessverfahren 1 bis 250 µm beträgt, und der elektroplattierte Verbund-Film (11; 12; 13) entweder derart (A) konfiguriert ist, dass ein gleichzeitiges Abscheidungsausmaß der Diamantpartikel (3) in der Matrix (2) von der Basissubstratseite (1a), auf welcher der elektroplattierte Verbund-Film (11; 12; 13) ausgebildet ist, zu einer Filmoberflächenseite (1b) hin allmählich zunimmt; oder derart (B), dass ein gleichzeitiges Abscheidungsausmaß der Diamantpartikel (3) in der Matrix (2) von der Basissubstratseite (1a) zur Filmoberflächenseite (1b) hin allmählich abnimmt.

2. Kühlkörpermaterial (A1; A2; A3; A5) nach Anspruch 1, wobei sich die Diamantpartikel (3) an zumindest einem Teil des plattierten Metallfilms (2) einander gegenseitig berühren.

3. Kühlkörpermaterial (A1; A2; A3; A5) nach Anspruch 2, wobei das Flächenverhältnis von miteinander in Kontakt stehenden Diamantpartikeln (3) zur Gesamtbeobachtungsfläche bei 15 zu 60% liegt, wie durch ein Bildverarbeiten eines Dickenrichtungsquerschnitts des plattierten Metallfilms (2) bestimmt wird.

4. Kühlkörpermaterial (A1; A2; A3; A5) nach einem der Ansprüche 1 bis 3, wobei der elektroplattierte Verbund-Film (11; 12; 13) derart konfiguriert ist, dass ein gleichzeitiges Abscheidungsausmaß der Diamantpartikel (3) in der Matrix (2) von der Basissubstratseite (1a) zur Filmoberflächenseite (1b) hin allmählich zunimmt, und auf der Oberfläche (12b) des gleichzeitig abgeschiedenen Diamantfilms (12a), an der die Diamantpartikel (3) zu einer Oberfläche desselben hin freigelegt sind, mit einem plattierten Oberflächenmetallfilm (5) versehen ist, der aus einer Metallquelle gebildet ist, die sich von einer zur Ausbildung des matrixplattierten Metallfilms (2) verwendeten Metallquelle unterscheidet.

5. Kühlkörpermaterial (A1; A2; A3; A5) nach Anspruch 4, wobei der plattierte Oberflächenmetallfilm (5) eine Dicke von 1/2 bis 1/3 einer durchschnittlichen Partikelgröße der Diamantpartikel (3) aufweist.

6. Kühlkörpermaterial (A1; A2; A3; A5) nach Anspruch 4 oder 5, wobei die zur Ausbildung des plattierten Oberflächenmetallfilms (5) verwendete Metallquelle Kupfer, Silber, Gold oder Eisen ist.

7. Kühlkörpermaterial (A1; A2; A3; A5) nach einem der Ansprüche 1 bis 6, wobei eine Dicke des elektroplattierten Verbund-Films (11; 12; 13) bei 1 bis 5000 µm liegt.

8. Kühlkörpermaterial (A1; A2; A3; A5) nach einem der Ansprüche 1 bis 7, wobei die Metallquelle zur Ausbildung des matrixplattierten Metallfilms (2) aus einem oder zwei oder mehreren Elementen, die aus Kupfer, Nickel, Gold, Silber, Zinn, Kobalt, Eisen, Zink und Chrom ausgewählt sind, besteht.

9. Kühlkörpermaterial (A1; A2; A3; A5) nach einem der Ansprüche 1 bis 8, wobei ein geformter Glasartikel als das Basissubstrat (4) verwendet wird.

10. Kühlkörpermaterial (A1; A2; A3; A5) nach einem der Ansprüche 1 bis 8, wobei ein geformter Kunststoffartikel als das Basissubstrat (4) verwendet wird.

11. Kühlkörpermaterial (A1; A2; A3; A5) nach einem der Ansprüche 1 bis 10, wobei ein plattierter Metallfilm (6), der aus einer Metallquelle gebildet ist, die sich von einer zur Ausbildung des matrixplattierten Metallfilms (2) verwendeten Metallquelle unterscheidet, zwischen dem elektroplattierten Verbund-Film (11; 12; 13) und dem Basissubstrat (4) angeordnet ist.

12. Kühlkörpermaterial (A1; A2; A3; A5) nach Anspruch 11, wobei die Dicke des dazwischen angeordneten, plattierten Metallfilms (6) bei 1/4 bis 1/3 der Dicke des elektroplattierten Verbund-Films (11; 12; 13) liegt.

13. Verwendung des Kühlkörpermaterials (A1; A2; A3; A5) nach einem der Ansprüche 1 bis 12, als ein Kühlkörpermaterial für eine Halbleitervorrichtung.

14. Verwendung nach Anspruch 13, wobei für ein Mobiltelefon oder einen Personal-Computer ein Kühlkörpermaterial verwendet wird.

15. Verwendung des Kühlkörpermaterials (A1; A2; A3; A5) nach einem der Ansprüche 1 bis 12, als ein Kühlkörpermaterial für eine optische Vorrichtung.

## Revendications

1. Matériau dissipateur de chaleur (A1; A2 ; A3 ; A5) comprenant un substrat de base (4) et un film composite électroplaqué (11 ; 12 ; 13) formé sur une face de celui-ci, ledit film composite électroplaqué (11 ; 12 ; 13) comprenant un film de métal plaqué (2) en tant que matrice et des particules de diamant (3) qui sont co-déposées dans ladite matrice de telle manière qu'une quantité de co-dépôt de celles-ci change graduellement dans une direction d'épaisseur dudit film de métal plaqué (2),
dans lequel une taille de particule moyenne desdites particules de diamant (3) est comprise entre 1 et 250 µm lorsqu'elle est déterminée par un procédé de mesure de distribution de taille de particule du type à diffraction laser et le film composite électroplaqué (11 ; 12 ; 13) est configuré (A) de sorte qu'une quantité de co-dépôt desdites particules de diamant (3) dans ladite matrice (2) augmente graduellement à partir du côté de substrat de base (la), sur lequel est formé ledit film composite électroplaqué (11 ; 12 ; 13), vers un côté de surface de film (lb) ; ou (B) de sorte qu'une quantité de co-dépôt desdites particules de diamant (3) dans ladite matrice (2) diminue progressivement du côté de substrat de base (la) vers le côté de surface du film (lb).

2. Matériau dissipateur de chaleur (A1; A2 ; A3 ; A5) selon la revendication 1, dans lequel lesdites particules de diamant (3) sont mutuellement en contact les unes avec les autres au niveau d'au moins une partie dudit film métallique plaqué (2).

3. Matériau dissipateur de chaleur (A1; A2 ; A3 ; A5) selon la revendication 2, dans lequel le rapport de surface entre les particules de diamant en contact (3) et la surface totale observée est compris entre 15 et 60 %, comme déterminé par traitement d'image d'une section de direction d'épaisseur dudit film métallique plaqué (2).

4. Matériau dissipateur thermique (A1; A2 ; A3 ; A5) selon l'une quelconque des revendications 1 à 3, dans lequel ledit film composite électroplaqué (11; 12; 13) est configuré de telle sorte qu'une quantité de co-dépôt desdites particules de diamant (3) dans ladite matrice (2) augmente graduellement du côté de substrat de base (la) vers le côté de surface du film (lb) et est fourni, sur la surface (12b) du film co-déposé en diamant (12a) au niveau duquel lesdites particules de diamant (3) sont exposées sur une surface de celui-ci, avec un film métallique de surface plaqué (5) formé à partir d'une source de métal différente d'une source de métal utilisée pour former ledit film métallique plaqué de matrice (2).

5. Matériau dissipateur thermique (A1; A2 ; A3 ; A5) selon la revendication 4, dans lequel ledit film métallique de surface plaqué (5) a une épaisseur de 1/2 à 1/3 d'une taille de particule moyenne desdites particules de diamant. (3).

6. Matériau dissipateur thermique (A1; A2 ; A3 ; A5) selon la revendication 4 ou 5, dans lequel la source de métal utilisée pour former ledit film métallique de surface plaqué (5) est du cuivre, de l'argent, de l'or ou du fer.

7. Matériau dissipateur thermique (A1; A2 ; A3 ; A5) selon l'une quelconque des revendications 1 à 6, dans lequel l'épaisseur dudit film composite électroplaqué (11 ; 12 ; 13) est comprise entre 1 et 5 000 µm.

8. Matériau dissipateur de chaleur (A1; A2 ; A3 ; A5) selon l'une quelconque des revendications 1 à 7, dans lequel la source de métal pour former ledit film métallique plaqué de matrice (2) est constituée d'un ou deux ou plus choisis parmi le cuivre, le nickel, l'or, l'argent, l'étain, le cobalt, le fer, le zinc et le chrome.

9. Matériau dissipateur de chaleur (A1; A2 ; A3 ; A5) selon l'une quelconque des revendications 1 à 8, dans lequel un article en verre moulé est utilisé comme substrat de base (4).

10. Matériau dissipateur thermique (A1; A2 ; A3 ; A5) selon l'une quelconque des revendications 1 à 8, dans lequel un article en plastique moulé est utilisé comme substrat de base (4).

11. Matériau dissipateur thermique (A1; A2 ; A3 ; A5) selon l'une quelconque des revendications 1 à 10, dans lequel un film métallique plaqué (6) formé à partir d'une source de métal différente de la source de métal utilisée pour former ledit film métallique plaqué de matrice (2) est interposé entre ledit film composite électroplaqué (11 ; 12 ; 13) et ledit substrat de base (4).

12. Matériau dissipateur de chaleur (A1; A2 ; A3 ; A5) selon la revendication 11, dans lequel l'épaisseur dudit film métallique plaqué interposé (6) est comprise entre 1/4 et 1/3 de l'épaisseur dudit film composite électroplaqué. (11 ; 12 ; 13).

13. Utilisation du matériau dissipateur de chaleur (A1; A2; A3 ; A5) selon l'une quelconque des revendications 1 à 12, en tant que matériau dissipateur de chaleur pour un dispositif à semi-conducteur.

14. Utilisation selon la revendication 13, dans laquelle l'utilisation intervient en tant que matériau dissipateur de chaleur pour un téléphone cellulaire ou un ordinateur personnel.

15. Utilisation du matériau dissipateur de chaleur (A1; A2; A3; A5) selon l'une quelconque des revendications 1 à 12 en tant que matériau dissipateur de chaleur pour un dispositif optique.
